(19) Europäisches Patentamt
European Patent Office
Office européen des brevets

(11) **EP 2 999 998 B1**

(12) **EUROPÄISCHE PATENTSCHRIFT**

(45) Veröffentlichungstag und Bekanntmachung des Hinweises auf die Patenterteilung:
**08.08.2018 Patentblatt 2018/32**

(21) Anmeldenummer: **14727174.6**

(22) Anmeldetag: **20.05.2014**

(51) Int Cl.:
**G05B 17/02** *(2006.01)*     **G06F 17/16** *(2006.01)*
**G06F 17/50** *(2006.01)*     **G05B 13/04** *(2006.01)*

(86) Internationale Anmeldenummer:
**PCT/EP2014/060350**

(87) Internationale Veröffentlichungsnummer:
**WO 2014/187828 (27.11.2014 Gazette 2014/48)**

(54) **METHODE ZUR ERMITTLUNG EINES MODELLS EINER AUSGANGSGRÖSSE EINES TECHNISCHEN SYSTEMS**

METHODS FOR ASCERTAINING A MODEL OF AN OUTPUT VARIABLE OF A TECHNICAL SYSTEM

MÉTHODE DE DÉTERMINATION D'UN MODÈLE D'UNE GRANDEUR DE SORTIE D'UN SYSTÈME TECHNIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.05.2013 AT 503472013**

(43) Veröffentlichungstag der Anmeldung:
**30.03.2016 Patentblatt 2016/13**

(73) Patentinhaber: **AVL List GmbH**
**8020 Graz (AT)**

(72) Erfinder:
• STADLBAUER, Markus
A-1020 Wien (AT)
• JAKUBEK, Stefan
A-1230 Wien (AT)
• DEREGNAUCOURT, Maxime
A-1050 Wien (AT)
• RAINER, Andreas
A-8047 Kainbach bei Graz (AT)
• LANSCHÜTZER, Herbert
A-8054 Graz (AT)
• ZETTEL, Karl
A-8124 Übelbach (AT)
• DIDCOCK, Nico
A-3012 Wolfsgraben (AT)
• HAMETNER, Christoph
A-1020 Wien (AT)

(74) Vertreter: **Patentanwälte Pinter & Weiss OG**
**Prinz-Eugen-Straße 70**
**1040 Wien (AT)**

(56) Entgegenhaltungen:
**WO-A1-2012/163972**

• **MARKUS STADLBAUER ET AL: "Online measuring method using an evolving model based test design for optimal process stimulation and modelling", 2013 IEEE INTERNATIONAL INSTRUMENTATION AND MEASUREMENT TECHNOLOGY CONFERENCE (I2MTC), IEEE, 13 May 2012 (2012-05-13), pages 1314-1319, XP032451288, ISSN: 1091-5281, DOI: 10.1109/I2MTC.2012.6229185**
• **BENJAMIN HARTMANN ET AL: "Model-based design of experiments based on local model networks for nonlinear processes with low noise levels", 2011 AMERICAN CONTROL CONFERENCE (ACC 2011) : SAN FRANCISCO, CALIFORNIA, USA, 29 JUNE - 1 JULY 2011, IEEE, PISCATAWAY, NJ, 29 June 2011 (2011-06-29), pages 5306-5311, XP032034559, ISBN: 978-1-4577-0080-4**

**Beschreibung**

Die gegenständliche Erfindung betrifft eine Methode zur Ermittlung eines Modells für eine Ausgangsgröße eines technischen Systems, die in nichtlineare Weise von einer Anzahl von Eingangsgrößen in Form eines Eingangsgrößenvektors abhängig ist, wobei als Modell eine Modellstruktur mit Modellparametern vorgegeben wird und die Modellparameter in einem iterativen Verfahren anhand von gemessenen Ausgangsgrößen aus Prüfstandversuchen am technischen System optimiert werden und die Prüfstandversuche einem Versuchsplan folgen, der für jeden Iterationsschritt aus geschätzten Ausgangsgrößen des Modells erstellt wird.

Die Ausgangsgrößen vieler technischer Systeme sind mehrdimensional nichtlinear und abhängig von einer Vielzahl von Parametern. Ein typisches Beispiel ist ein Verbrennungsmotor, bei dem viele Kenngrößen (Ausgangsgrößen), wie z.B. $NO_x$-Emissionen, Ruß im Abgas, Verbrauch, etc., von verschiedensten Eingangsgrößen (bzw. Betriebspunkten), wie z.B. Drehzahl, Drehmoment, Temperatur, Lage der Drallklappe, Treibstoffdruck, etc., abhängig sind. Allgemein wird unter technischem System ein System verstanden, bei dem eine Anzahl bestimmter Eingangsgrößen, wie z.B. Einstellungen von Aktuatoren, eine Anzahl bestimmter Ausgangsgrößen, z.B. Kenngrößen oder mit Sensoren messbare Größen, bewirken, bei dem also ein beliebiger funktioneller Zusammenhang zwischen Eingangs- und Ausgangsgrößen vorliegt. Bei der Entwicklung solcher technischer Systeme ist es sehr aufwändig, die Entwicklung ausschließlich auf einem Prüfstand vorzunehmen, da die vielen voneinander und von verschiedenen Eingangsgrößen abhängigen nichtlinearen Ausgangsgrößen manuell kaum optimierbar sind, was ein mögliches Entwicklungsziel ist. Daher wurde schon versucht, solche technischen Systeme bzw. bestimmte Ausgangsgrößen in Abhängigkeit von Eingangsgrößen und Systemparametern mittels mathematischer Modellen nachzubilden, anhand deren man den Einfluss von Eingangsgrößenvariationen oder Modellparametervariationen simulieren und studieren kann und Optimierungen vornehmen kann, die dann z.B. am Prüfstand verifiziert werden. Dazu sind sogenannte modellbasierte Methoden (model based design of experiments) bekannt geworden, z.B. aus der WO 2012/163 972 A1, die anhand einer mathematischen Methode und von Messwerten ein Modell eines nichtlinearen technischen Systems identifizieren. Dabei wird eine Modellstruktur gewählt, z.B. ein bekanntes Local Model Network (LMN) oder ein bekanntes Multilayer Perceptron (MLP), und die Modellparameter werden anhand von aus Prüfstandversuchen (online) erhaltenen Daten geschätzt. Dabei erzeugt das Modell iterativ Ausgangsgrößen, die in einem Versuchsplan verwendet werden, um für den nächsten Iterationsschritt neue Eingangsgrößen zu erzeugen, die am Prüfstand für das technische System abgefahren werden. Die Ausgangsgrößen der Prüfstandversuche werden dann unter Berücksichtigung von bestimmten Randbedingungen verwendet, um die Modellparameter zu verbessern. Das wird solange wiederholt bis ein vorgegebenes Abbruchkriterium erfüllt ist, also bis die Modellparameter ausreichend genau geschätzt wurden. Dabei ist es für die Schätzung der Modellparameter wichtig, dass der Versuchsplan die ganze Dynamik und den ganzen Ausgangsbereich des technischen Systems abdeckt, um eine ausreichende Modellqualität im gesamten Ausgangsbereich zu erzielen.

Aus Stadlbauer, M., et al., "Online Measuring Method Using an Evolving Model Based Test Design for Optimal Process Stimulation and Modelling", Instrumentation and Measurement Technology Conference (I2MTC), 2012 IEEE International, 13. Mai 2012, S.1314-1319 geht ein Verfahren zum Erstellen eines Versuchsplans hervor, das auf einem modellprädiktiven Verfahren beruht. Dabei wird anhand eines Modells eines technischen Systems um einen definierten Prädiktionshorizont in die Zukunft gerechnet und die Determinante der Fisher Informationsmatrix über die zukünftigen Eingangsgrößen maximiert. Für den Versuchsplan wird die nächste Eingangsgröße herangezogen und damit das Modell trainiert. Auch dieses Verfahren deckt den gesamten möglichen Ausgangsbereich des Modells ab.

Viele Kenngrößen eines technischen Systems sind aber nur in bestimmten Bereichen interessant, sei es weil es gesetzliches Vorschriften gibt, die Vorgaben zu Kenngrößen in bestimmten Parameterbereichen machen, oder sei es weil eine Kenngröße nur in bestimmten Parameterbereichen aussagekräftig ist. Ein typisches Beispiel dafür sind die $NO_x$- oder RußEmissionen eines Verbrennungsmotors, die in bestimmten Betriebsbereichen des Verbrennungsmotors vom Gesetzgeber vorgegebene Grenzwerte einhalten müssen. Ein Modell für eine solche Kenngröße müsste daher nur innerhalb dieses Zielausgangsbereichs genau sein, nicht aber für den gesamten möglichen Ausgangsbereich.

Die Methode zur modellbasierten Modellidentifikation nach der WO 2012/163 972 A1 oder nach Stadlbauer, M., et al., "Online Measuring Method Using an Evolving Model Based Test Design for Optimal Process Stimulation and Modelling", Instrumentation and Measurement Technology Conference (I2MTC), 2012 IEEE International, 13. Mai 2012, S.1314-1319 erstellt jedoch ein Modell, das für den gesamten Ausgangsbereich gültig ist, was einerseits mit hohem Aufwand, insbesondere für die notwendigen Prüfstandversuche, verbunden ist. Andererseits kann es sein, dass das Modell ausgerechnet im Zielausgangsbereich nicht ausreichend genaue Ergebnisse liefert, weil bei der Modellidentifikation zu wenige Trainingsdaten im Zielausgangsbereich verwendet wurden. Damit wäre ein solches Modell auch nur bedingt für diesen Zielausgangsbereich brauchbar.

Aus Picheny, V., et al., "Adaptive Designs of Experiments for Accurate Approximation of a Target Region", Journal of Mechanical Design, Vol. 132, Juli 2010, 071008-1 bis 071008-9 geht ein Verfahren hervor, bei dem ein Versuchsplan erstellt wird, sodass ein Metamodell in der Nähe eines engen Zielbereichs Ausgangsgrößen möglichst genau schätzt. Als Metmodell wird ein Kriging-Modell verwendet und der Zielbereich ist als Konturlinie definiert. Das Modell soll daher sehr genau um eine Konturlinie schätzen, aber nicht innerhalb eines größeren Zielausgangsbereichs, wofür diese Methode nicht geeignet ist. Dabei kommt ein sequentielles design of experiments Verfahren zur Anwendung, bei dem eine neue Eingangsgröße nach einem Optimierungskriterium in Abhängigkeit von den schon bekannten Eingangsgrößen und von deren zugehörigen berechneten Ausgangsgrößen gewählt wird. Dieses Verfahren kommt daher ohne Prüfstandversuche aus. Das Ziel dieser Methode ist daher auch nicht die Optimierung anhand von konkreten Messwerten aus Prüfstandversuchen am realen System, sondern mehr die Anpassung einer Funktion an eine vorgegebene Konturlinie.

Es ist eine Aufgabe der gegenständlichen Erfindung, eine Methode zur Ermittlung eines Modells für eine Ausgangsgröße eines technischen Systems anzugeben, bei dem zur Optimierung Prüfstandversuche verwendet werden, wobei das Verfahren mit möglichst geringem Aufwand für Prüfstandversuche auskommen soll und das geschätzte Modell in einem großen Zielausgangsbereich eine hohe Genauigkeit aufweisen soll.

Diese Aufgabe wird dadurch gelöst, indem mit dem für den aktuellen Iterationsschritt gültigen Modell aus einer Menge von Eingangsgrößenvektoren eine Menge von Ausgangsgrößen ermittelt wird, aus dieser Menge von Ausgangsgrößen diejenigen Ziel-Eingangsgrößenvektoren bestimmt werden, die zu einer Ausgangsgröße innerhalb eines vorgegebenen Zielausgangsgrößenbereichs führen, wobei der Zielausgangsgrößenbereich ein Teilbereich des gesamten Ausgangsgrößenbereichs ist, aus den bestimmten Ziel-Eingangsgrößenvektoren für den nächsten Iterationsschritt ein neuer Eingangsgrößenvektor zur Ergänzung der Menge der Eingangsgrößenvektoren ausgewählt wird, wobei der neue Eingangsgrößenvektor anhand eines vorgegebenen abstandsbasierten Auswahlkriteriums ausgewählt wird, die derart erweiterte Menge von ausgewählten Eingangsgrößenvektoren als Versuchsplan verwendet wird, um anhand von Prüfstandversuchen Messdaten der Ausgangsgröße zu erzeugen, mit denen das Modell optimiert wird und die obigen Verfahrensschritten iterativ wiederholt werden, bis ein vorgegebenes Abbruchkriterium erfüllt wird. Durch dieses Verfahren wird das Modell gezielt in einem definierten Zielausgangsgrößenbereich trainiert, wofür weniger Prüfstandversuche benötigt werden und trotzdem eine sehr hohe Genauigkeit im Zielausgangsgrößenbereich erzielt werden kann.

Als abstandsbasiertes Auswahlkriterium kommt ein Kriterium im Eingangsgrößenbereich, im Ausgangsgrößenbereich oder im Eingangs-/Ausgangsgrößenbereich in Frage.

Als besonders günstig hat sich die Verwendung eines lokalen Modellnetzwerkes als Modellstruktur erwiesen, da dieses einen geringen Rechenaufwand verlangt, vorhandene Kenntnisse des technischen Systems verwendet werden können und zu Modellparametern führt, die in robuster Weise für die Versuchsplanung verwendet werden können.

Die gegenständliche Erfindung wird nachfolgend unter Bezugnahme auf die Figuren 1 bis 10 näher erläutert, die beispielhaft, schematisch und nicht einschränkend vorteilhafte Ausgestaltungen der Erfindung zeigen. Dabei zeigt

Fig.1 schematisch den Ablauf des erfindungsgemäßen Verfahrens,

Fig.2 bis 4 verschiedene Iterationsstufen des erfindungsgemäßen Verfahrens für ein abstandsbasiertes Auswahlkriterium im Eingangs-/Ausgangsgrößenbereich,

Fig.5 bis 7 einen Vergleich der verschiedenen Auswahlkriterien mit einer herkömmlichen Methode zur Modellidentifikation,

Fig.8 einen Vergleich der mittleren quadratischen Fehler bei Anwendung der verschiedenen Auswahlkriterien und einer herkömmlichen Methode zur Modellidentifikation und

Fig.9 und 10 die Anwendung des erfindungsgemäßen Verfahrens auf die Ermittlung eines Modells für die $NO_x$-Emissionen eines Verbrennungsmotors.

Für das erfindungsgemäße Verfahren ist zuerst ein Modell mit einer Modellstruktur zu wählen, mit der das Verhalten des technischen Systems für eine Kenngröße bzw. Ausgangsgrößen in Abhängigkeit von bestimmten Eingangsgrößen geschätzt werden soll. Die nachfolgende Beschreibung des Verfahren wird anhand eines sogenannten, bekannten lokalen Modellnetzwerkes (local model network, LMN) beschrieben. Es ist allerdings anzumerken, dass das Verfahren in gleicher Weise auch mit anderen bekannten Modellstrukturen, wie z.B. Multilayer Perceptrons, Support Vector Machines oder Gaußprozessen, umgesetzt werden kann. Ein lokales Modellnetzwerk zeichnet sich aber durch einen niedrigen Computeraufwand, die Möglichkeit der Verwendung bestehender Kenntnisse des technischen Systems und durch Modellparameter, die in robuster Weise für die Versuchsplanung verwendet werden können, aus und ist daher besonders für das erfindungsgemäße Verfahren geeignet, weshalb die Erfindung nachfolgend anhand eines lokalen Modellnetzwerkes LMN als Modellstruktur beschrieben wird.

Ein lokales Modellnetzwerk LMN besteht aus I lokalen Modellen $\hat{y}_j(u; \vartheta_j)$, die nur lokal, also für bestimmte Eingangsgrößen, gültig sind. $u$ bezeichnet dabei den $n$-dimensionalen Eingangsgrößenvektor des technischen Systems, der alle Eingangsgrößen enthält, und $\vartheta_j$ die Modellparameter des j-ten lokalen Modells. Die lokalen Modelle $\hat{y}_j(u; \vartheta_j)$ sind hier quadratische Mehrfachregressionsmodelle mit Interaktionstermen, wobei es allerdings anzumerken ist, dass auch andere Modellstrukturen für die lokalen Modelle verwendet werden können, wie z.B. lineare oder kubische Mehrfachregressionsmodelle. Der Ausgang des lokalen Modellnetzwerkes $\hat{y}(u)$ ist die gewichtete Summe der Ausgänge der

lokalen Modelle $\hat{y}_j(u;\vartheta_j)$ und ist ein Schätzwert für den Systemausgang. Dazu wird eine Gültigkeitsfunktion $\Phi_j(\tilde{x})$ definiert, die den Gültigkeitsbereich der lokalen Modelle $\hat{y}_j(u;\vartheta_j)$ festlegt, wobei $\tilde{x}$ ausgewählte Eingangsgrößen des Eingangsgrößenvektors **u** bezeichnet. Der Ausgang des lokalen Modellnetzwerks $\hat{y}(u)$ ergibt sich dann bekanntermaßen zu

$$\hat{y}(u) = \sum_{j=1}^{I} \Phi_j(\tilde{x})\hat{y}_j(u;\vartheta_j).$$

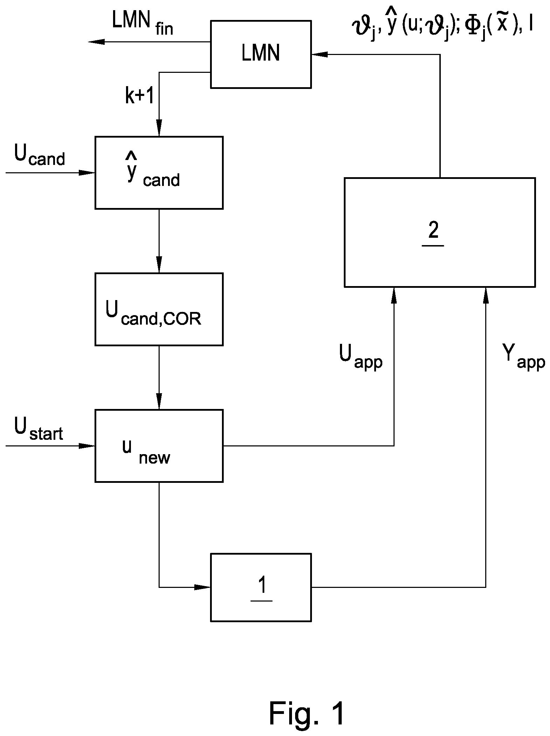

Das lokale Modellnetzwerk LMN benötigt Trainingsdaten, um den Zusammenhang zwischen Eingangsgrößen **u** und der Ausgangsgröße y des technischen Systems zu schätzen. Durch das Training in einer Trainingseinheit 2 können neben den Modellparametern $\vartheta_j$ auch die Anzahl I der lokalen Modelle $\hat{y}_j(u;\vartheta_j)$ und deren Gültigkeitsfunktionen $\Phi_j(\tilde{x})$ bestimmt werden. Das ist an sich hinlänglich bekannt, z.B. aus Hametner, C., et al., "Local model network identification for online engine modelling", 2013, Information Sciences 220 (0), S.210-225, sodass hier nicht näher darauf eingegangen wird. Die Trainingsdaten stammen aus einem Versuchsplan, der wie nachfolgend anhand von Fig.1 beschrieben erstellt wird.

Ausgangspunkt ist, dass das Modell nicht im gesamten möglichen Ausgangsgrößenbereich genau schätzen muss, sondern nur in einem definierten Zielausgangsgrößenbereich. Z.B. sind Verbrennungsmotoren so zu kalibrieren, dass bestimmte Ausgangsgrößen, wie z.B. $NO_x$- oder Rußemissionen, für bestimmte Eingangsgrößen gewisse Vorgaben einhalten. Damit ist der Zielausgangsgrößenbereich bekannt, die zugehörigen Eingangsgrößen des Modells aber nicht. Es ist daher ein Versuchsplan erforderlich, der diese Eingangsgrößen identifiziert und die Modellparameter $\vartheta_j$ des Modells, und gegebenenfalls auch die Anzahl I der lokalen Modelle und deren Gültigkeitsfunktionen, für den Zielausgangsgrößenbereich parametrisiert.

Als Versuchsplan ist eine Abfolge, unter Umständen auch eine zeitliche Abfolge, von Eingangsgrößen zu verstehen, die am Prüfstand des technischen Systems eingestellt werden und dabei die gewünschte Ausgangsgröße des technischen Systems beobachtet bzw. gemessen wird. Am Prüfstand, z.B. ein Motorprüfstand, wird das technische System, z.B. ein Verbrennungsmotor, angeordnet, gegebenenfalls mit einer Belastungsmaschine, z.B. ein elektrischer Dynamometer, verbunden und der Prüfstand bzw. das technische System bzw. die Belastungsmaschine gemäß dem Versuchsplan gesteuert.

Der Versuchsplan basiert auf einer iterativen Auswahl von Eingangsgrößenvektoren $u_{cand}$ aus einer Eingangsgrößenvektorenmenge $U_{cand}$. Als Eingangsgrößenvektorenmenge $U_{cand}$ kann jede beliebige Menge von möglichen Eingangsgrößenvektoren $u_{cand}$ verwendet werden, die den gesamten Eingangsgrößenbereich möglichst gleichmäßig abdeckt. Die Eingangsgrößenvektorenmenge $U_{cand}$ wird vorab festgelegt und wird für das Verfahren als bekannt angenommen.

Ein Eingangsgrößenvektor $u_{cand}$ kann für den Versuchsplan nur einmal angewendet werden. Am Beginn des Verfahrens wird eine Menge $U_{start}$ von Eingangsgrößenvektoren $u_{start}$ vorgegebenen. In jedem Iterationsschritt wird also ein neuer Eingangsgrößenvektor $u_{new}$ zuallererst aus der Eingangsgrößenvektorenmengen $U_{start}$ und dann aus der Eingangsgrößenvektorenmenge $U_{cand}$ ausgewählt und die Reaktion des technischen Systems auf diesen Eingangsgrößenvektor $u_{new}$ in Form einer Ausgangsgrößen $y_{new}$ durch einen Prüfstandversuch auf einem Prüfstand 1 für das technische System gemessen. Die Menge $U_{app}$ der schon bekannten bzw. ausgewählten Eingangsgrößenvektoren $u_{app}$ (inklusive des neuen Eingangsgrößenvektors $u_{new}$) und die Menge $Y_{app}$ der zugehörigen gemessenen Ausgangsgrößen $y_{app}$ bilden die Trainingsdaten für das Training des lokalen Modellnetzwerkes LMN in der Trainingseinheit 2 (z.B. ein geeigneter Computer mit Software und implementierten Algorithmen für die Durchführung des Trainings). In jedem Iterationsschritt k wird daher das lokale Modellnetzwerk LMN mit diesen Trainingsdaten trainiert. Das Training kann aber auch nur in manchen Iterationsschritten eine Veränderung des lokalen Modellnetzwerkes LMN, z.B. der Netzwerkdimension I oder der Modellparameter $\vartheta_j$, verursachen. Bei der Veränderung des Modells werden die Modellparameter $\vartheta_j$, und gegebenenfalls auch die Anzahl I der lokalen Modelle $\hat{y}_j(u;\vartheta_j)$ sowie deren Gültigkeitsfunktionen $\Phi_j(\tilde{x})$, gemäß den Regeln des lokalen Modellnetzwerkes LMN aktualisiert, wie z.B. in Hametner, C., et al., "Local model network identification for online engine modelling", 2013, Information Sciences 220 (0), S.210-225 beschrieben.

Dadurch wächst die Menge $U_{app}$ der schon ausgewählten Eingangsgrößenvektoren $u_{app}$ und die Menge $Y_{app}$ der zugehörigen gemessenen Ausgangsgrößen $y_{app}$ ständig, bis ein ausreichend genaues Modell $LMN_{fin}$ für den Zielausgangsbereich erreicht wurde. Das kann durch ein geeignetes Abbruchkriterium festgestellt werden, z.B. eine maximale Anzahl von Trainingsdaten oder einen Schwellenwert, unterhalb dessen der mittlere quadratische Modellfehler im Zielausgangsbereich sein muss. Die Auswahl des neuen Eingangsgrößenvektors $u_{new}$ erfolgt dabei gemäß folgendem Verfahren.

Zuerst werden anhand des im jeweiligen Iterationsschritt k aktuellen lokalen Modellnetzwerks LMN die durch das aktuelle Modell geschätzten Ausgangsgrößen $\hat{y}(u_{cand})$ für die Eingangsgrößenvektorenmenge $U_{cand}$ ermittelt. Danach werden daraus alle Eingangsgrößenvektoren $u_{cand,COR}$ bestimmt, deren geschätzten Ausgangsgrößen $\hat{y}_{cand,COR}$ im Zielausgangsgrößenbereich (custom output range, COR), der durch dessen Grenzen $y_{min}$ und $y_{max}$ definiert ist (COR = $[y_{min};y_{max}]$), liegen und diese werden in der Ziel-Eingangsgrößenvektorenmenge $U_{cand,COR}$ zusammengefasst.

$$U_{cand,COR} = \left\{ u_{cand} \in U_{cand} \mid y_{\min} \leq \hat{y}(u_{cand}) \leq y_{\max} \right\}$$

Aus dieser Ziel-Eingangsgrößenvektorenmenge U_{cand,COR} wird nun in jedem Iterationsschritt k der neue Eingangsgrößenvektor **u**_{new} ausgewählt. Dabei wird eine möglichst gleichmäßige Verteilung im Eingangsgrößenraum, im Ausgangsgrößenraum oder im Eingangs-Ausgangsgrößenraum angestrebt. Der Hintergrund dazu ist der, dass das lokale Modellnetzwerk LMN, bzw. allgemein das Modell, in der Nähe der Trainingsdaten genauer ist, als weiter entfernt von den Trainingsdaten. Wenn die Trainingsdaten möglichst gleichmäßig verteilt werden, wird folglich die Modellunsicherheit reduziert. Aus diesem Grund wird für die Auswahl des neuen Eingangsgrößenvektors **u**_{new} ein abstandsbasiertes Kriterium (auch als S-optimales Design oder maximin distance design bekannt) angewendet. Dabei ist das Ziel des abstandsbasierten Auswahlkriteriums, den minimalen Abstand zwischen Designpunkten (hier Eingangsgröße und/oder Ausgangsgröße) zu maximieren. Dazu können nun drei abstandsbasierte Auswahlkriterien definiert werden:

Abstandsbasiertes Auswahlkriterium im Eingangsgrößenbereich:

Es wird aus der Ziel-Eingangsgrößenvektorenmenge U_{cand,COR} jener Eingangsgrößenvektor **u**_{cand,COR} als neuer Eingangsgrößenvektor **u**_{new} ausgewählt, der den größtmöglich kleinsten euklidischen Abstand zu den schon bekannten Eingangsgrößenvektoren **u**_{app} in der Menge U_{app} aufweist, für den also gilt:

$$u_{new} = \arg\max_{u_{cand,COR} \in U_{cand,COR}} \min_{u_{app} \in U_{app}} \sqrt{\left(u_{app} - u_{cand,COR}\right)^T \left(u_{app} - u_{cand,COR}\right)}.$$

Dieses Kriterium führt zu einer gleichmäßigen Verteilung der ausgewählten Eingangsgrö-ßenvektoren im Eingangsgrößenbereich.

Abstandsbasiertes Auswahlkriterium im Ausgangsgrößenbereich:

Zuerst werden mit dem aktuell gültigen Modell zur Eingangsgrößenvektorenmenge U_{cand,COR} die Ausgangsgrößen $\hat{y}(u_{cand,COR})$ berechnet. Der neue Eingangsgrößenvektor **u**_{new} hat die Ausgangsgröße

$$\hat{y}_{new} = \arg\max_{\hat{y}_{cand,COR} \in \hat{y}(U_{cand,COR})} \min_{y_{app} \in Y_{app}} \sqrt{\left(y_{app} - \hat{y}_{cand,COR}\right)^2},$$

also die Ausgangsgröße, die den größtmöglich kleinsten euklidischen Abstand zu den schon bekannten Ausgangsgrößen aufweist, und der zugehörige neue Eingangsgrößenvektor **u**_{new} ergibt sich dann aus

$$u_{new} = \left\{ u_{cand,COR} \in U_{cand,COR} \mid \hat{y}(u_{cand,COR}) = \hat{y}_{new} \right\}.$$

Dieses Kriterium führt zu einer gleichmäßigen Verteilung der Ausgangsgrößen im Zielausgangsgrößenbereich.

Abstandsbasiertes Auswahlkriterium im Eingangs-/Ausgangsgrößenbereich:

Hier wird die Menge der bereits gewählten Eingangsgrößenvektoren U_{app} um die zugehörigen Ausgangsgrößen Y_{app} ergänzt, $U_{app}^* = \begin{bmatrix} U_{app} & Y_{app} \end{bmatrix}$, und die Ziel-Eingangsgrößenvektorenmenge U_{cand,COR} wird um die zugehörigen geschätzten Ausgangsgrößen $\hat{y}(U_{cand,COR})$ ergänzt, $U_{cand,COR}^* = \begin{bmatrix} U_{cand,COR} & \hat{y}(U_{cand,COR}) \end{bmatrix}$. Der neue Eingangsgrößenvektor **u**_{new} ergibt sich dann aus dem Kriterium

$$\begin{bmatrix} u_{new} & \hat{y}(u_{new}) \end{bmatrix} = \arg\max_{u_{cand,COR}^* \in U_{cand,COR}^*} \min_{u_{app}^* \in U_{app}^*} \sqrt{\left(u_{app}^* - u_{cand,COR}^*\right)^T \left(u_{app}^* - u_{cand,COR}^*\right)}.$$

Hier wird also die Eingangsgröße mit dem größtmöglich kleinsten euklidische Abstand zu den schon bekannten Eingangsgrößen und dem größtmöglich kleinsten euklidische Abstand der zugehörigen Ausgangsgröße zu den schon bekannten Ausgangsgrößen gesucht. Dieses Kriterium führt zu einer gleichmäßigen Verteilung der Eingangsgrößen im Eingangsgrößenbereich und der Ausgangsgrößen im Zielausgangsgrößenbereich.

Das derart trainierte lokale Modellnetzwerk LMN$_{fin}$ ist dann in der Lage, den Ausgang y des technischen Systems innerhalb eines Zielausgangsgrößenbereichs mit der gewünschten Genauigkeit (vorgegeben durch das gewählte Abbruchkriterium) zu schätzen. Das trainierte Modellnetzwerk LMN kann dann z.B. für die Entwicklung des technischen Systems eingesetzt werden, z.B. um Steuereinheiten eines Verbrennungsmotors so zu kalibrieren, dass vorgegebene Grenzwerte für die Ausgangsgröße eingehalten werden.

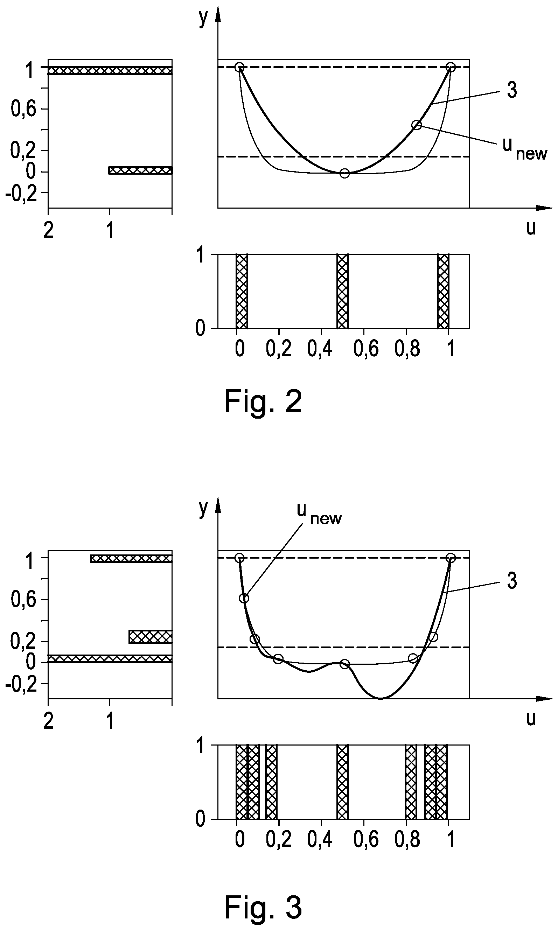

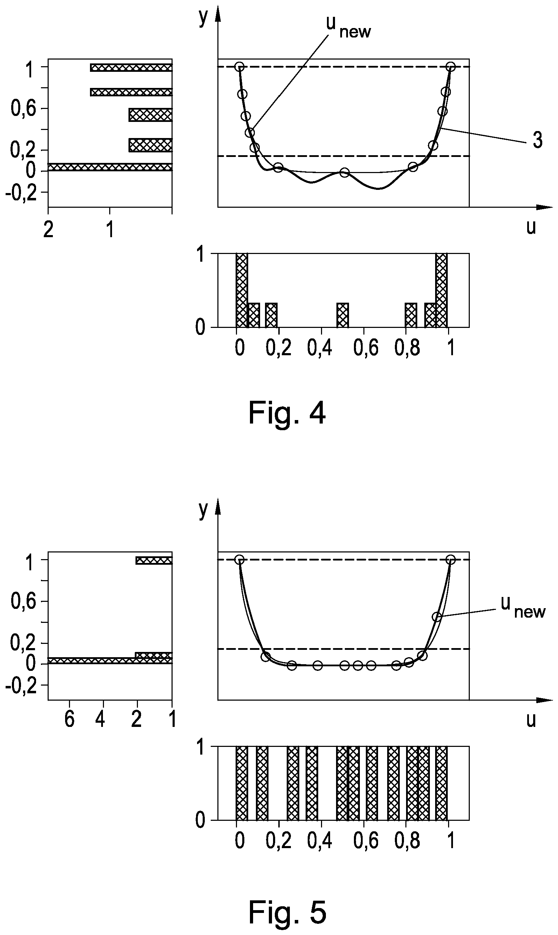

Das erfindungsgemäße Verfahren soll anhand der Figs.2 bis 4 anhand einer badewannenähnlichen Funktion f (y=f(u)), die von einer eindimensionalen Eingangsgrößen u abhängig ist, und anhand eines abstandsbasierten Auswahlkriteriums im Eingangs-/Ausgangsgrößenbereich demonstriert werden. Diese Funktion f zeigt ein stark nichtlineares Verhalten in den Eingangsgrößenbereichen u=[0 ; 0,2] und u=[0,8 ; 1], und ist fast linear im Eingangsgrößenbereich u=[0,2 ; 0,8]. Der Zielausgangsgrößenbereich, in dem das Modell (ein lokales Modellnetzwerk LMN) hinreichend genau parametrisiert werden soll, soll für das Beispiel durch y$_{min}$=0.15 und y$_{max}$=1 definiert sein. Mit der Kurve 3 in Fig.2 ist das Anfangsmodell mit drei gewählten Anfangs-Eingangsgrößen u$_{start}$ in der Menge U$_{app}$ dargestellt. Die beiden strichlierten Linien markieren den Zielausgangsgrößenbereich. Für jede Achse ist die Häufigkeit der Punkte im Eingangs- und Ausgangsbereich in Form von Balken dargestellt. Die neue anhand des Verfahrens ermittelte Eingangsgröße u$_{new}$ ist in Fig.2 ebenfalls dargestellt. In Fig.3 ist das Modell nach der Auswahl von sieben Eingangsgrößen in der Menge U$_{app}$ und die Reaktion des aktuellen Modells in Form der Ausgangsgrößen y$_{app}$ dargestellt. Fig.4 zeigt das Modell nach der Auswahl von elf Eingangsgrößen in der Menge U$_{app}$, womit das Verfahren gestoppt wird (die neue Eingangsgröße u$_{new}$ wird nicht mehr berücksichtigt). Anhand der Fig.2 bis Fig.4 erkennt man, dass das Verfahren das Modell systematisch im definierten Zielausgangsgrößenbereich parametrisiert, wodurch das Modell darin sehr genau, außerhalb dieses Bereichs aber ungenau ist. An den Häufigkeitsverteilungen erkennt man auch eine sehr gleichmäßige Verteilung der Punkte im Eingangs- und Ausgangsbereich zum interessierenden Zielausgangsbereich (gemäß dem gewählten Auswahlkriterium). Außerdem erkennt man, dass das Verfahren in der Lage ist, beide Äste der Ausgangsfunktion gleichermaßen abzudecken.

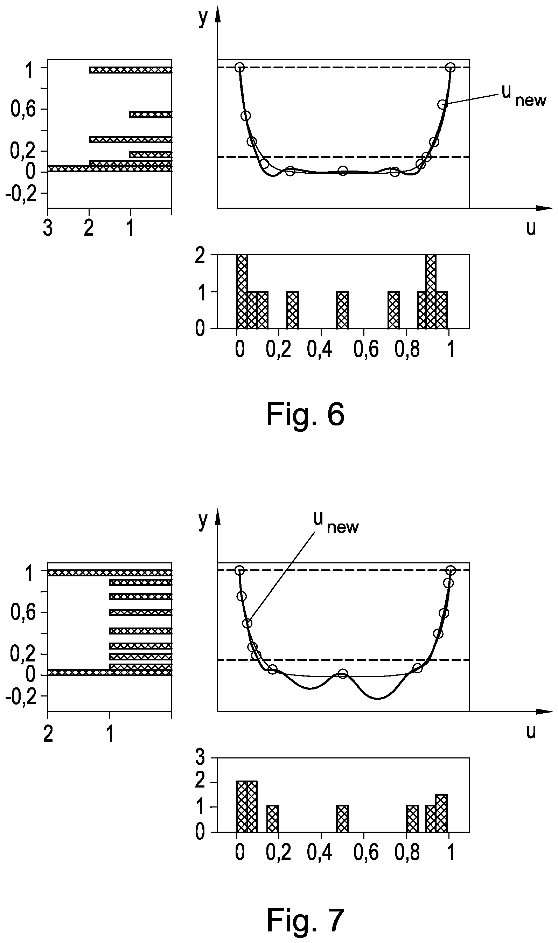

Mit dem Figs.5 bis 7 werden die verschiedenen abstandsbasierten Auswahlkriterien nach jeweils elf ausgewählten Eingangsgrößen miteinander verglichen. Fig.5 zeigt das Ergebnis mit einem Verfahren nach dem Stand der Technik ohne Zielausgangsgrößenbereich. Es ist zu erkennen, dass die zwar Eingangsgrößen sehr gleichmäßig verteilt sind, aber keine Eingangsgröße mit Ausgangsgröße im Zielausgangsbereich parametrisiert wurde, womit das Modell im Zielausgangsgrößenbereich unbrauchbar ist. In Fig.6 wird ein oben beschriebenes abstandsbasiertes Auswahlkriterium im Eingangsgrößenbereich angewendet, was zur Auswahl von vier Eingangsgrößen mit Ausgangsgröße im Zielausgangsgrößenbereich führt. In Fig.7 wird ein oben beschriebenes abstandsbasiertes Auswahlkriterium im Ausgangsgrö-ßenbereich angewendet, was zur Auswahl von sechs Eingangsgrößen mit Ausgangsgröße im Zielausgangsgrößenbereich führt.

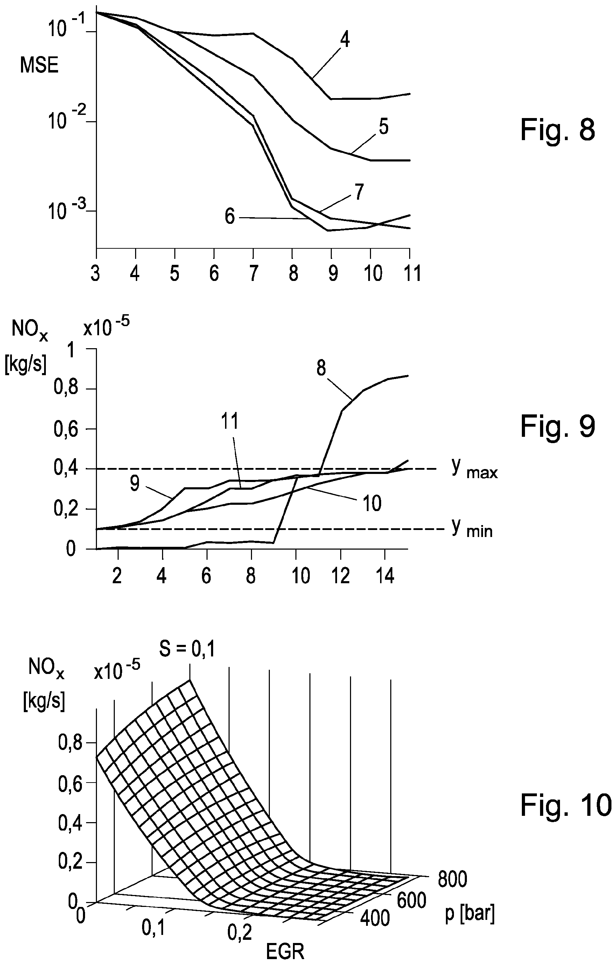

In Fig.8 ist noch der mittlere quadratische Fehler (MSE) der verschiedenen Verfahren dargestellt (auf einer logarithmischen Skala). Die Kurve 4 zeigt dabei den MSE für ein Verfahren ohne Zielausgangsgrößenbereich, Kurve 5 das Verfahren mit abstandsbasiertem Auswahlkriterium im Eingangsgrößenbereich, Kurve 6 das Verfahren mit abstandsbasiertem Auswahlkriterium im Ausgangsgrößenbereich und Kurve 7 das Verfahren abstandsbasiertem Auswahlkriterium im Eingangs-/Ausgangsgrößenbereich. Daraus ist ersichtlich, dass ein abstandsbasiertes Auswahlkriterium bei gleichzeitiger Berücksichtigung eines Zielausgangsgrößenbereiches die Modellqualität gegenüber einem Verfahren ohne Zielausgangsgrößenbereich durch erheblich kleinere Modellfehler verbessert. Qualitativ scheint dabei ein abstandsbasiertes Auswahlkriterium im Eingangs-/Ausgangsgrößenbereich besser zu sein, als die anderen abstandsbasierten Auswahlkriterien.

Ein modellbasierter Versuchsplan mit einem Zielausgangsgrößenbereich ist daher ein effizientes Verfahren, das das Modell des technischen Prozesses im Zielausgangsgrößenbereich parametrisiert, um den Eingangsgrößenbereich zu reduzieren, was zu einer verbesserten Modellqualität im Zielausgangsgrößenbereich führt. Gleichzeitig werden dadurch zur Erzielung einer gleichen Modellqualität die notwendige Anzahl der benötigten Prüfstandversuche reduziert.

Nachfolgend soll das erfindungsgemäße Verfahren noch an einem praktischen Beispiel in Form der NO$_x$-Emissionen eines Verbrennungsmotors (Ausgangsgröße y) in Abhängigkeit der Eingangsgrößen Lage der Drallklappe (S), Treibstoffdruck (p) und Abgasrückführung (EGR) (Eingangsgrößenvektor **u**), für eine bestimmte Drehzahl und eine bestimmte Last erläutert werden. Als Zielausgangsgrößenbereich wird die NO$_x$-Emission im Bereich von y$_{min}$=0,1x10$^{-5}$Kg/s und y$_{max}$=0,4x10$^{-5}$kg/s definiert. Das zugrunde liegende Modell, hier z.B. in Form eines lokalen Modellnetzwerkes LMN, wird anhand des erfindungsgemäßen Verfahrens systematisch für den Zielausgangsgrößenbereich parametrisiert. Wie in Fig.9 ersichtlich, werden durch das Modell die Ausgangsgrößen durch das erfindungsgemäße Verfahren im Zielausgangsgrößenbereich geschätzt. Die Kurve 8 zeigt dabei das Ergebnis für fünfzehn ausgewählte Eingangsgrößen für ein Verfahren ohne Zielausgangsgrößenbereich, Kurve 9 das Ergebnis mit abstandsbasiertem Auswahlkriterium im Eingangsgrößenbereich, Kurve 10 das Ergebnis mit abstandsbasiertem Auswahlkriterium im Ausgangsgrößenbereich und Kurve 11 das Ergebnis abstandsbasiertem Auswahlkriterium im Eingangs-/Ausgangsgrößenbereich. Mit Fig.10 ist letztendlich die mit dem ermittelten Modell geschätzte $NO_x$-Emission für eine konstante Lage der Drallklappe S=0,1 und für eine bestimmte Drehzahl und eine bestimmte Last dargestellt.

**Patentansprüche**

1. Methode zur Ermittlung eines Modells für eine Ausgangsgröße (y) eines technischen Systems, die in nichtlineare Weise von einer Anzahl von Eingangsgrößen in Form eines Eingangsgrößenvektors (**u**) abhängig ist, wobei als Modell eine Modellstruktur mit Modellparametern vorgegeben wird und die Modellparameter in einem iterativen Verfahren anhand von gemessenen Ausgangsgrößen aus Prüfstandversuchen am technischen System optimiert werden und die Prüfstandversuche einem Versuchsplan folgen, der für jeden Iterationsschritt (k) aus geschätzten Ausgangsgrößen ($\hat{y}$) des Modells erstellt wird, **dadurch gekennzeichnet, dass** mit dem für den aktuellen Iterationsschritt (k) gültigen Modell aus einer Menge ($U_{cand}$) von Eingangsgrößenvektoren ($\mathbf{u}_{cand}$) eine Menge ($\hat{y}(U_{cand})$) von geschätzten Ausgangsgrößen ($\hat{y}(u_{cand})$) ermittelt wird, **dass** aus dieser Menge ($\hat{y}(U_{cand})$) von Ausgangsgrößen diejenigen Ziel-Eingangsgrößenvektoren ($\mathbf{u}_{cand,COR}$) der Ziel-Eingangsgrößenvektorenmenge ($U_{cand,COR}$) bestimmt werden, die zu einer geschätzten Ausgangsgröße ($\hat{y}(u_{cand})$) innerhalb eines vorgegebenen Zielausgangsgrößenbereichs (COR) führen, wobei der Zielausgangsgrößenbereich (COR) ein Teilbereich des gesamten Ausgangsgrößenbereichs ist, **dass** aus der Ziel-Eingangsgrößenvektorenmenge ($U_{cand,COR}$) für den nächsten Iterationsschritt (k+1) ein neuer Eingangsgrößenvektor ($\mathbf{u}_{new}$) zur Ergänzung der Menge ($U_{app}$) der bereits ausgewählten Eingangsgrößenvektoren ($\mathbf{u}_{app}$) ausgewählt wird, wobei der neue Eingangsgrößenvektor ($\mathbf{u}_{new}$) anhand eines vorgegebenen abstandsbasierten Auswahlkriteriums ausgewählt wird, **dass** die derart erweiterte Menge ($U_{app}$) von ausgewählten Eingangsgrö-ßenvektoren ($\mathbf{u}_{app}$) als Versuchsplan verwendet wird, um anhand von Prüfstandversuchen Messdaten der Ausgangsgröße ($y_{app}$) zu erzeugen, mit denen das Modell optimiert wird **und dass** die obigen Verfahrensschritte iterativ wiederholt werden, bis ein vorgegebenes Abbruchkriterium erfüllt wird.

2. Methode nach Anspruch 1, **dadurch gekennzeichnet, dass** aus der Ziel-Eingangsgrößenvektorenmenge ($U_{cand,COR}$) jener Eingangsgrößenvektor ($\mathbf{u}_{cand,COR}$) als neuer Eingangsgrößenvektor ($\mathbf{u}_{new}$) ausgewählt, der den größtmöglich kleinsten euklidischen Abstand zu den schon bekannten Eingangsgrößenvektoren ($\mathbf{u}_{app}$) in der Menge ($U_{app}$) der ausgewählten Eingangsgrößenvektoren aufweist.

3. Methode nach Anspruch 1, **dadurch gekennzeichnet, dass** mit dem aktuell gültigen Modell zur Ziel-Eingangsgrößenvektorenmenge ($U_{cand,COR}$) die Ausgangsgrößen ($\hat{y}(u_{cand,COR})$) berechnet werden und als neuer Eingangsgrö-ßenvektor ($\mathbf{u}_{new}$) derjenige Eingangsgrößenvektor ($\mathbf{u}_{cand,COR}$) ausgewählt wird, dessen geschätzte Ausgangsgröße ($\hat{y}(u_{cand,COR})$) den größtmöglich kleinsten euklidischen Abstand zu den schon bekannten Ausgangsgrößen ($y_{app}$) aufweist.

4. Methode nach Anspruch 1, **dadurch gekennzeichnet, dass** die Menge der bereits gewählten Eingangsgrößenvektoren ($U_{app}$) um die zugehörigen Ausgangsgrößen ($Y_{app}$) und die Ziel-Eingangsgrößenvektorenmenge ($U_{cand,COR}$) um die zugehörigen geschätzten Ausgangsgrößen ($\hat{y}(U_{cand,COR})$) ergänzt wird und als neuer Eingangsgrößenvektor ($\mathbf{u}_{new}$) derjenige Eingangsgrößenvektor ($\mathbf{u}_{cand,COR}$) ausgewählt wird, der den größtmöglich kleinsten euklidischen Abstand zu den schon bekannten Eingangsgrößenvektoren ($\mathbf{u}_{app}$) und dessen zugehörige Ausgangsgröße ($\hat{y}(u_{cand,COR})$) den größtmöglich kleinsten euklidische Abstand zu den schon bekannten Ausgangsgrößen ($y_{app}$) aufweist.

5. Methode nach Anspruch 1, **dadurch gekennzeichnet, dass** als Modell ein lokales Modellnetzwerk (LMN) mit einer Anzahl (I) von lokalen Modellen ($\hat{y}_j(u;\vartheta_j)$) mit Modellparametern ($\vartheta_j$) und zugehörigen Gültigkeitsfunktionen ($\Phi_j(\tilde{x})$) verwendet wird und in einem Iterationsschritt (k) anhand der ausgewählten Eingangsgrößen ($\mathbf{u}_{app}$) und der gemessenen Ausgangsgrößen ($y_{app}$) die Anzahl (I) der lokalen Modelle ($\hat{y}_j(u;\vartheta_j)$), die Modellparameter ($\vartheta_j$) und/oder die zugehörigen Gültigkeitsfunktionen ($\Phi_j(\tilde{x})$) angepasst werden.

**Claims**

1. A method for determining a model for an output quantity (y) of a technical system that is dependent in a nonlinear manner on a number of input quantities in the form of an input quantity vector (**u**), wherein a model structure with model parameters is given as the model and the model parameters are optimized on the technical system in an iterative method on the basis of measured output quantities from bench tests, and the bench tests follow an experimental design that is prepared for each iteration step (k) from estimated output quantities ($\hat{y}$) of the model, **char-**

**acterized in that,** using the model that is valid for the current iteration step (k), a set ($\hat{y}(U_{cand})$) of estimated output quantities ($\hat{y}(u_{cand})$) is determined from a set ($U_{cand}$) of input quantity vectors ($\mathbf{u}_{cand}$), **that** the target input quantity vectors ($\mathbf{u}_{cand,COR}$) of the set of input quantity vectors ($U_{cand,COR}$) that lead to an estimated output quantity ($\hat{y}(u_{cand})$) within a predetermined target output quantity range (COR) are determined from this set ($\hat{y}(U_{cand})$) of output quantities, wherein target output quantity range (COR) is a subrange of the entire output quantity range, **that** a new input quantity vector ($\mathbf{u}_{new}$) is selected from the set of input quantity vectors ($U_{cand,COR}$) in order to supplement the set ($U_{app}$) of the already selected input quantity vectors ($U_{app}$) for the next iteration step (k+1), wherein the new input quantity vector ($\mathbf{u}_{new}$) being selected on the basis of a predetermined distance-based selection criterion, **that** the set ($U_{app}$) of selected input quantity vectors ($\mathbf{u}_{app}$) enlarged in this way is used as an experimental design in order to generate measured data of the output quantity ($y_{app}$) by means of bench tests with which the model is optimized, and **that** the above method steps are repeated iteratively until a predetermined abort criterion is met.

2. The method as set forth in claim 1, **characterized in that** the input quantity vector ($\mathbf{u}_{cand,COR}$) having the greatest possible minimum Euclidean distance to the already known input quantity vectors ($\mathbf{u}_{app}$) in the set ($U_{app}$) of selected input quantity vectors is selected from the set of input quantity vectors ($U_{cand,COR}$) as the new input quantity vector ($\mathbf{u}_{new}$).

3. The method as set forth in claim 1, **characterized in that** the output quantities ($\hat{y}(u_{cand,COR})$) are calculated using the currently valid model for the set of input quantity vectors ($U_{cand,COR}$) and the input quantity vector ($\mathbf{u}_{cand,COR}$) whose estimated output quantity ($\hat{y}(u_{cand,COR})$) has the greatest possible minimum Euclidean distance to the already known output quantities ($y_{app}$) is selected as the new input quantity vector ($\mathbf{u}_{new}$).

4. The method as set forth in claim 1, **characterized in that** the set of already selected input quantity vectors ($U_{app}$) is supplemented by the associated output quantities ($Y_{app}$) and the set of target input quantity vectors ($U_{cand,COR}$) is supplemented by the associated estimated output quantities ($\hat{y}(U_{cand,COR})$), and the input quantity vector ($\mathbf{u}_{cand,COR}$) that has the greatest possible minimum Euclidean distance to the already known input quantity vectors ($\mathbf{u}_{app}$) and whose associated output quantity ($\hat{y}(u_{cand,COR})$) has the greatest possible minimum Euclidean distance to the already known output quantities ($y_{app}$) is selected as the new input quantity vector ($\mathbf{u}_{new}$).

5. The method as set forth in claim 1, **characterized in that** a local model network (LMN) with a number (l) of local models ($\hat{y}_j(u;\vartheta_j)$) with model parameters ($\vartheta_j$) and associated validity functions ($\Phi_j(\tilde{x})$) is used as the model and, in an iteration step (k), the number (l) of local models ($\hat{y}_j(u;\vartheta_j)$) the model parameters ($\vartheta_j$) and/or the associated validity functions ($\Phi_j(\tilde{x})$) are adapted on the basis of the selected input quantities ($\mathbf{u}_{app}$) and the measured output quantities ($y_{app}$).

**Revendications**

1. Procédé de détermination d'un modèle pour une grandeur de sortie (y) d'un système technique qui est dépendante de manière non linéaire d'un nombre de grandeurs d'entrée se présentant sous la forme d'un vecteur de grandeur d'entrée (u), une structure de modèle comportant des paramètres de modèle étant prédéfinie comme modèle et les paramètres de modèle étant optimisés dans un procédé itératif sur la base de grandeurs de sortie mesurées provenant de tests en banc d'essai au niveau du système technique et les tests en banc d'essai suivant un programme de tests qui est établi pour chaque étape d'itération (k) à partir de grandeurs de sortie ($\hat{y}$) du modèle, **caractérisé en ce que,** avec le modèle valable pour l'étape d'itération (k) actuelle, l'on détermine à partir d'un ensemble ($U_{cand}$) de vecteurs de grandeurs d'entrée ($U_{cand}$) un ensemble ($\hat{y}(U_{cand})$) de grandeurs de sortie ($\hat{y}(u_{cand})$ estimées, **en ce que,** à partir de cet ensemble ($\hat{y}(U_{cand})$) de grandeurs de sortie, on détermine les vecteurs de grandeurs d'entrée cible ($\mathbf{u}_{cand,COR}$) de l'ensemble de vecteurs de grandeurs d'entrée cible ($U_{cand,COR}$) qui conduisent à une grandeur de sortie ($\hat{y}(U_{cand})$) estimée à l'intérieur d'une zone de grandeurs de sortie cible (COR) prédéfinie, la zone de grandeurs de sortie cible (COR) étant une zone partielle de la zone totale des grandeurs de sortie, **en ce que,** à partir de l'ensemble de vecteurs des grandeurs d'entrée cible ($U_{cand,COR}$) pour la prochaine étape d'itération (k+1), on choisit un nouveau vecteur de grandeurs d'entrée ($\mathbf{u}_{new}$) pour compléter l'ensemble ($U_{app}$) des vecteurs de grandeurs d'entrée ($\mathbf{u}_{app}$) déjà choisis, le nouveau vecteur de grandeurs d'entrée ($\mathbf{u}_{new}$) étant choisi à l'aide d'un critère de sélection prédéfini basé sur la distance , **en ce que** l'ensemble ($U_{app}$) ainsi étendue de vecteurs de grandeurs d'entrée ($\mathbf{u}_{app}$) choisis est utilisée comme programme de tests pour générer, sur la base ds tests en banc d'essai, des données de mesure de la grandeur de sortie ($y_{app}$), avec lesquelles le modèle est optimisé **et en ce que** les étapes de procédé ci-dessus sont répétées de manière itérative jusqu'à ce qu'un critère d'interruption prédéfini soit rempli.

**2.** Procédé selon la revendication 1, **caractérisé en ce que,** à partir de l'ensemble de vecteurs de grandeurs d'entrée cible ($U_{cand,COR}$), on choisit chaque vecteur de grandeurs d'entrée ($u_{cand,COR}$) comme nouveau vecteur de grandeurs d'entrée ($u_{new}$), qui présente la distance euclidienne la plus petite possible par rapport aux vecteurs de grandeurs d'entrée ($u_{app}$) déjà connus dans l'ensemble ($U_{app}$) des vecteurs de grandeurs d'entrée choisis.

**3.** Procédé selon la revendication 1, **caractérisé en ce que** les grandeurs de sortie ($\hat{y}(u_{cand,COR})$) sont calculées avec le modèle actuellement valable de l'ensemble de vecteurs de grandeurs d'entrée cible ($U_{cand,COR}$) et le vecteur de grandeurs d'entrée ($u_{cand,COR}$) est choisi comme nouveau vecteur de grandeurs d'entrée ($u_{new}$), dont la grandeur de sortie ($\hat{y}(u_{cand,COR})$) estimée présente la distance euclidienne la plus petite possible par rapport aux grandeurs de sortie ($y_{app}$) déjà connues.

**4.** Procédé selon la revendication 1, **caractérisé en ce que** l'ensemble des vecteurs de grandeurs d'entrée ($U_{app}$) déjà choisis est complété par les grandeurs de sortie ($Y_{app}$) associées et l'ensemble de vecteurs de grandeurs d'entrée cible ($U_{cand,COR}$) est complété par les grandeurs de sortie ($\hat{y}(U_{cand,COR})$) estimées associées et le vecteur de grandeurs d'entrée ($u_{cand,COR}$) choisi comme nouveau vecteur de grandeurs d'entrée ($u_{new}$) est celui qui présente la distance euclidienne la plus petite possible par rapport aux vecteurs de grandeurs d'entrée ($u_{app}$) déjà connus et dont les grandeurs de sortie ($\hat{y}(U_{cand,COR})$) associées présentent la distance euclidienne la plus petite possible par rapport aux grandeurs de sortie ($y_{app}$) déjà connues.

**5.** Procédé selon la revendication 1, **caractérisé en ce qu'**un réseau de modèles locaux (LMN) comportant un nombre (l) de modèles locaux ($\hat{y}_j(u;\vartheta_j)$) comportant des paramètres de modèle ($\vartheta_j$) et des fonctions de validité ($\Phi_j(\tilde{x})$) associées est utilisé comme modèle et, le nombre (l) de modèles locaux ($\hat{y}_j(u;\vartheta_j)$), les paramètres de modèle ($\vartheta_j$) et/ou les fonctions de validité ($\Phi_j(\tilde{x})$) associées sont adaptés dans une étape d'itération (k) sur la base des grandeurs d'entrée ($u_{app}$) choisies et des grandeurs de sortie ($y_{app}$) mesurées.

Fig. 1

Fig. 2

Fig. 3

Fig. 4

Fig. 5

Fig. 6

Fig. 7

Fig. 8

Fig. 9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2012163972 A1

**In der Beschreibung aufgeführte Nicht-Patentliteratur**

- **STADLBAUER, M. et al.** Online Measuring Method Using an Evolving Model Based Test Design for Optimal Process Stimulation and Modelling. *Instrumentation and Measurement Technology Conference (I2MTC), 2012 IEEE International,* 13. Mai 2012, 1314-1319

- **PICHENY, V. et al.** Adaptive Designs of Experiments for Accurate Approximation of a Target Region. *Journal of Mechanical Design,* Juli 2010, vol. 132, 071008-1-071008-9
- **HAMETNER, C. et al.** Local model network identification for online engine modelling. *Information Sciences,* 2013, vol. 220 (0), 210-225